# EUROPEAN PATENT APPLICATION

(11) **EP 4 692 748 A1**
(43) Date of publication of application: **11.02.2026**
(21) Application number: 25188537.2
(22) Date of filing: 09.07.2025
(51) Int. Cl.: G01L 9/00

(54) **PRESSURE SENSORS WITH HIGH-PRESSURE SEALING**

(30) Priority: 08.08.2024 IN 202411059880
(71) Applicant: Honeywell International Inc., Charlotte, NC 28202 (US)
(72) Inventor: GANGARAJU,, Charlotte, 28202 (US); BALEKUNDRI, Vishwanath, Charlotte, 28202 (US)
(74) Representative: Haseltine Lake Kempner LLP

(57) **Abstract**

A pressure sensor comprising a hex bolt assembly comprising a hex port and an inlet that is coupled to a base of the hex port; a header that is configured at the base of the hex port, wherein the header comprises (i) a groove within a circumference of the header and (ii) an O-ring in the groove that forms a sealing joint between the groove and a sidewall of the hex port; and a retainer ring that is configured in the hex port to retain the header between the retainer ring and the inlet.

## Description

### TECHNICAL FIELD

Various embodiments of the present disclosure relate to pressure sensors, and more particularly to designs for high-pressure sealing of pressure sensors.

### BACKGROUND

Pressure sensors may be used in high pressure applications that involve measurement of hostile media in harsh environment conditions. Existing pressure sensor designs may comprise a plurality of components that are joined to achieve a desired high pressure sealing. For example, components of a conventional high pressure sensor may comprise joints that require precise machining and welding. Moreover, any flaw in seating, fitting, and/or welding of the joints may cause sealing issues.

Applicant has identified many technical challenges and difficulties associated with providing high-pressure sealing of conventional pressure sensors.

### BRIEF SUMMARY

Various embodiments described herein relate to components and apparatuses for measuring pressure of media.

In accordance with various embodiments of the present disclosure, a pressure sensor is provided. In some embodiments, the pressure sensor comprises a hex bolt assembly comprising a hex port and an inlet that is coupled to a base of the hex port; a header that is configured at the base of the hex port, wherein the header comprises (i) a groove within a circumference of the header and (ii) an O-ring in the groove that forms a sealing joint between the groove and a sidewall of the hex port; and a retainer ring that is configured in the hex port to retain the header between the retainer ring and the inlet.

In some embodiments, the retainer ring is welded in the hex port. In some embodiments, the header further comprises a sensor die that is (i) integrated within a cavity of the header and (ii) interfaced with the inlet. In some embodiments, the pressure sensor further comprises one or more electrical contacts; and a printed circuit board assembly that is coupled to the one or more electrical contacts and the sensor die. In some embodiments, the one or more electrical contacts are (i) soldered to the printed circuit board assembly, and (ii) configured to conduct electrical output generated by the sensor die. In some embodiments, the inlet is configured to receive and guide media from a pressure line to the hex port. In some embodiments, the hex port comprises a cylindrically-shaped inner cavity that is defined by an inner cavity sidewall within the hex bolt assembly. In some embodiments, the hex port comprises a plain bore inner cavity sidewall. In some embodiments, the retainer ring comprises a tubular shape with a uniform or tapered circumference that is approximately equal to or less than a circumference of the hex port.

According to another embodiment, a pressure sensor comprises a hex bolt assembly comprising a hex port and an inlet that is coupled to a base of the hex port; a header that is configured at the base of the hex port, wherein the header comprises (i) a groove within a circumference of the header and (ii) an O-ring in the groove that forms a sealing joint between the groove and a sidewall of the hex port; and a circlip that is configured in the hex port to retain the header between the circlip and the inlet.

In some embodiments, the hex port comprises a hex port groove. In some embodiments, the hex port groove is provided a distance from an end of the hex port opposite of the inlet that, when the header is seated at the base of the hex port, allows for clearance above the header. In some embodiments, the circlip is configured in the hex port groove. In some embodiments, the circlip is configured to retain the header in the hex port by pinning the header below the circlip when the circlip is configured in the hex port groove. In some embodiments, the header further comprises a sensor die that is (i) integrated within a cavity of the header and (ii) interfaced with the inlet. In some embodiments, the inlet is configured to receive and guide media from a pressure line to the hex port. In some embodiments, the hex port comprises a cylindrically-shaped inner cavity that is defined by an inner cavity sidewall within the hex bolt assembly. In some embodiments, the header further comprises a sensor die that is (i) integrated within a cavity of the header and (ii) interfaced with the inlet. In some embodiments, the pressure sensor further comprises one or more electrical contacts; and a printed circuit board assembly that is coupled to the one or more electrical contacts and the sensor die. In some embodiments, the one or more electrical contacts are (i) soldered to the printed circuit board assembly, and (ii) configured to conduct electrical output generated by the sensor die.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1A is a perspective view of an example pressure sensor;
FIG. 1B is an exploded cross-sectional view of an example pressure sensor;
FIG. 1C and FIG. 1D depict cross-sectional views of an example pressure sensor;
FIG. 2A is a perspective view of an example pressure sensor in accordance with some embodiments of the present disclosure;
FIG. 2B is an exploded cross-sectional view of an example pressure sensor in accordance with some embodiments of the present disclosure;
FIG. 2C is a cross-sectional view of an example pressure sensor in accordance with some embodiments of the present disclosure;
FIG. 3A is a perspective view of an example pressure sensor in accordance with some embodiments of the present disclosure;
FIG. 3B is an exploded cross-sectional view of an example pressure sensor in accordance with some embodiments of the present disclosure; and
FIG. 3C is a cross-sectional view of an example pressure sensor in accordance with some embodiments of the present disclosure.

### DETAILED DESCRIPTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc., are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

As described above, there are many technical challenges and difficulties associated with providing high-pressure sealing for pressure sensors.

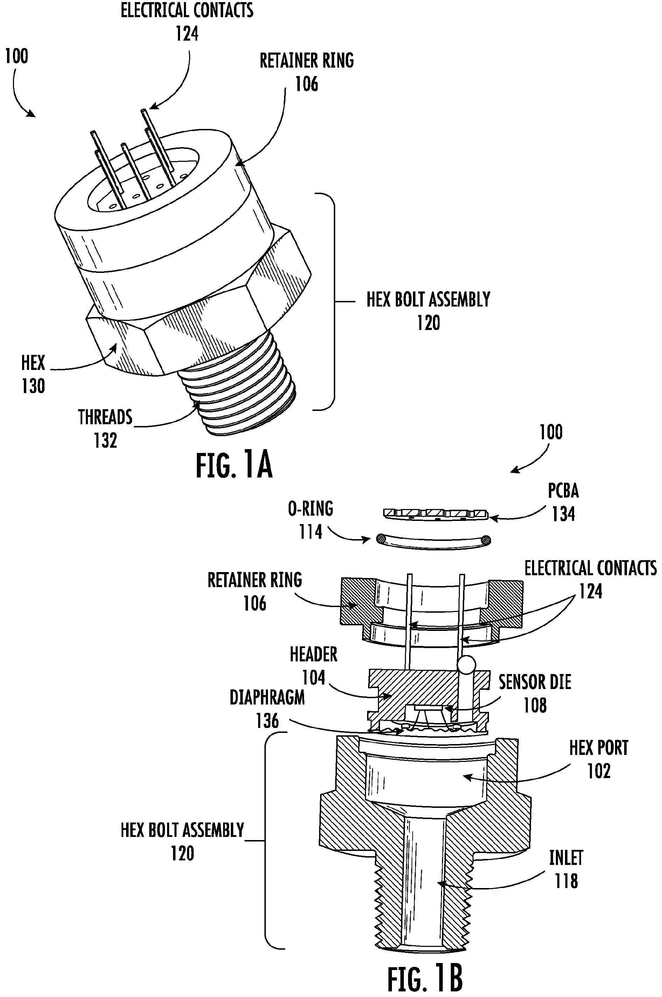

FIG. 1A is a perspective view of an example pressure sensor 100. As depicted in FIG. 1A, the pressure sensor 100 comprises a hex bolt assembly 120, a plurality of electrical contacts 124, and a retainer ring 106. The plurality of electrical contacts 124 may be coupled to sensor electronics that are housed within the hex bolt assembly 120. The retainer ring 106 may comprise a ring that is affixed to an electrical contact (e.g., electrical contacts 124) end of the hex bolt assembly 120 and configured to retain the sensor electronics and other pressure sensor components within the hex bolt assembly 120. The hex bolt assembly 120 comprises a hex 130 and threads132. The hex 130 allows for a tool to apply torque on the hex bolt assembly 120 such that the threads 132 may be fastened or unfastened to a system measured.

FIG. 1B is an exploded cross-sectional view of an example pressure sensor 100. The hex bolt assembly 120 further comprises a hex port 102 and an inlet 118. The hex port 102 may comprise a cylindrically-shaped inner cavity that is defined by an inner cavity sidewall within the hex bolt assembly 120. The inlet 118 may be configured to receive and guide media (e.g., fluids) from a pressure line to the hex port 102. The pressure sensor 100 further comprises a header 104. The header 104 comprises (i) a sensor die 108 that is integrated within a chamber of the header 104, (ii) a fill fluid within the chamber, and (iii) a diaphragm 136 that provides an interface between the sensor die 108, the fill fluid, and the inlet 118. A printed circuit board assembly (PCBA) 134 may comprise circuitry that is coupled to the electrical contacts 124 and the sensor die 108.

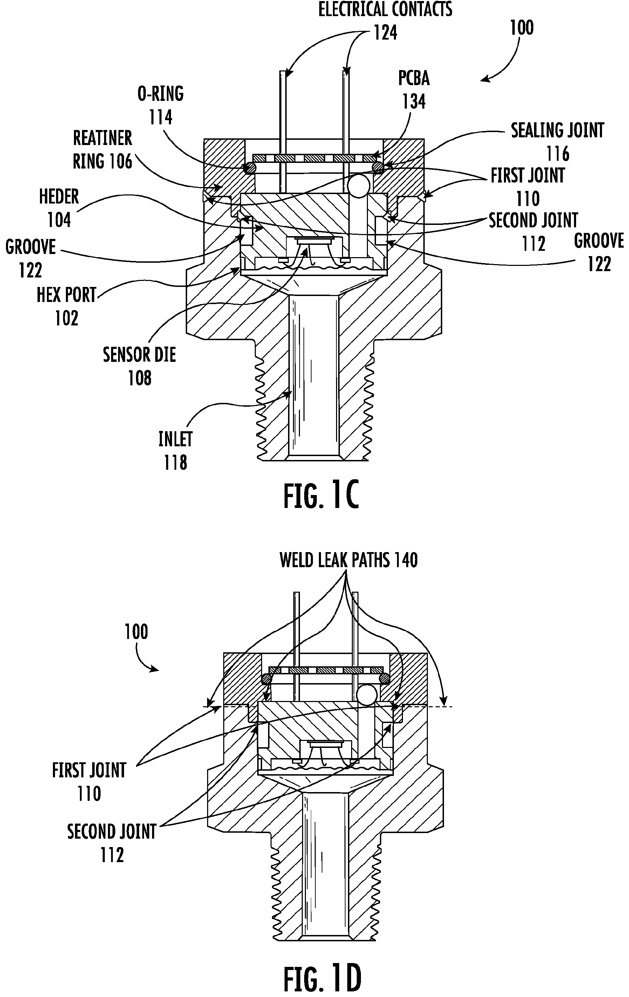

FIG. 1C and FIG. 1D depict cross-sectional views of an example pressure sensor 100. A header 104 is configured in a hex port 102 of the hex bolt assembly 120. The header 104 is configured within the hex port 102 wherein the sensor die 108 is (i) seated along with the header 104 at a base of the hex port 102 and (ii) facing the inlet 118. As such, media received at the inlet 118 may be measured by the sensor die 108.

The pressure sensor 100 further comprises a retainer ring 106 that is partially seated within the inner cavity of the hex port 202 and above the header 204. The retainer ring 106 comprises a plurality of exterior notched edges that complement and fit into a gap or groove formed between a portion of the hex port 102 (or inner cavity walls of the hex bolt assembly 120) and a portion of an outer surface wall of a header 104. As such, a plurality of contact points is formed between the retainer ring 106, the header 104, and the hex bolt assembly 120 comprising a first joint 110 and a second joint 112. The first joint 110 comprises an intersection of a collar edge of the hex bolt assembly 120 and a flange edge of the retainer ring 106. The second joint 112 comprises an intersection of (i) a notch comprising a portion of the hex port 102, (ii) a collar of the retainer ring 106, and (iii) an outcrop of the header 104. The first joint 110 and the second joint 112 may be further welded to provide seals that prevent leakage. In some embodiments, the first joint 110 may comprise a weld that joins an intersection of the collar edge of the hex bolt assembly 120 and the flange edge of the retainer ring 106. In some embodiments, the second joint 112 may comprise a weld that joins an intersection of (i) the notch comprising a portion of the hex port 102 and (ii) the outcrop of the header 104. An O-ring 114 is configured in an interior groove of the retainer ring 106 to provide an additional sealing joint 116.

Referring now to FIG. 1D, despite welding, weld leak paths 140 may form at the first joint 110 and the second joint 112. Furthermore, header 104 may comprise a groove 122 that is unutilized and does not serve any particular purpose in pressure sensor 100. Thus, the pressure sensor 100 comprises several disadvantages including (i) a need for precise welding at the first joint 110 and the second joint 112, (ii) unexploited machining of the header 104 to create groove 122, (iii) a need for precise machining for the hex port 102 or hex bolt assembly 120 and the retainer ring 106 to create the first joint 110 and the second joint 112, and (iv) high product cost, quality issues, and manufacturing lead time resulting from disadvantages caused by disadvantages (i) through (iii).

Various example embodiments of the present disclosure overcome the aforementioned technical challenges and difficulties in pressure sensors and provide various technical advancements and improvements. In accordance with various embodiments of the present disclosure, pressure sensor components and configurations of the pressure sensor components in example pressure sensors with improved high pressure sealing are disclosed. In some embodiments, a pressure sensor assembly comprises a hex port and a header that is seated within the hex port. The hex port may comprise a plain machined port that is interfaced with a header that (i) comprises a groove that is seated with an O-ring (ii) is secured in the hex port via (a) a retainer ring that is welded to the hex port or (b) a circlip that is configured in a groove within the hex port.

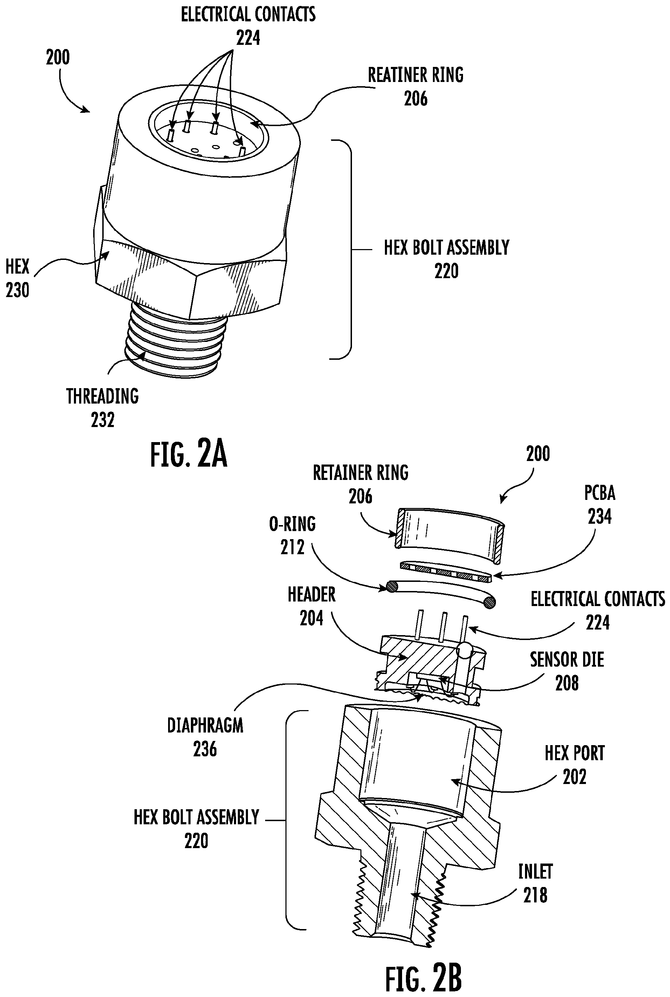

FIG. 2A is a perspective view of an example pressure sensor 200 in accordance with some embodiments of the present disclosure. The pressure sensor 200 comprises a hex bolt assembly 220, a plurality of electrical contacts 224, and a retainer ring 206. The plurality of electrical contacts 224 may be coupled to sensor electronics that are housed within the hex bolt assembly 220. The retainer ring 206 may comprise a ring that is inserted within an opening at an electrical contact (e.g., electrical contacts 224) end of the hex bolt assembly 220 and configured to retain the sensor electronics and other pressure sensor components within the hex bolt assembly 220. The hex bolt assembly 220 comprises a hex 230 and threads 232. The hex 230 allows for a tool to apply torque on the hex bolt assembly 220 such that the threads 232 may be fastened or unfastened to a system measured.

FIG. 2B is an exploded cross-sectional view of an example pressure sensor 200 in accordance with some embodiments of the present disclosure. The hex bolt assembly 220 further comprises a hex port 202 and an inlet 218. The hex port 202 may comprise a cylindrically-shaped inner cavity that is defined by an inner cavity sidewall within the hex bolt assembly 220. The inlet 218 is coupled to a base of the hex port 202. The inlet 218 may be configured to receive and guide media (e.g., fluids) from a pressure line (e.g., that may be coupled to the inlet 218) to the hex port 202. The pressure sensor 200 further comprises a header 204. The header 204 comprises (i) a sensor die 208 that is integrated within a chamber of the header 204, (ii) a fill fluid (e.g., silicon or transformer oil) within the chamber, and (iii) a diaphragm 236 that provides an interface between the sensor die 208, the fill fluid, and the inlet 218. A PCBA 234 may comprise circuitry that is coupled to the electrical contacts 224 and the sensor die 208. In some embodiments, the electrical contacts 224 are soldered to the PCBA 234 and configured to conduct electrical output generated by the sensor die 208 that is representative of a sensed pressure by the sensor die 208.

The sensor die 208 may comprise one or more elements that are configured to convert mechanical movement, stress and/or deflection of sensor die 208 into an electrical signal. In some embodiments, the sensor die 208 comprises piezoresistive materials that include any material that exhibits a change in electrical resistance in response to mechanical force or pressure applied to the material. For example, when force or pressure is applied to the sensor die 208, resistance between wire bonds that are connected by the piezoresistive materials may change in a time-varying manner that is based on an applied force. A signal representative of a magnitude of an applied force on the sensor die 208 may be generated by the sensor die 208 and transferred by electrical contacts 224 based on the change in the resistance.

The hex port 202 comprises a plain bore inner cavity sidewall without machined grooves or notches. Compared to the pressure sensor 100 of FIG. 1A through FIG. 1D, the hex port 202 excludes a notch that the hex port 102 comprises for joining with a collar of the retainer ring 106 or for welding at the second joint 112.

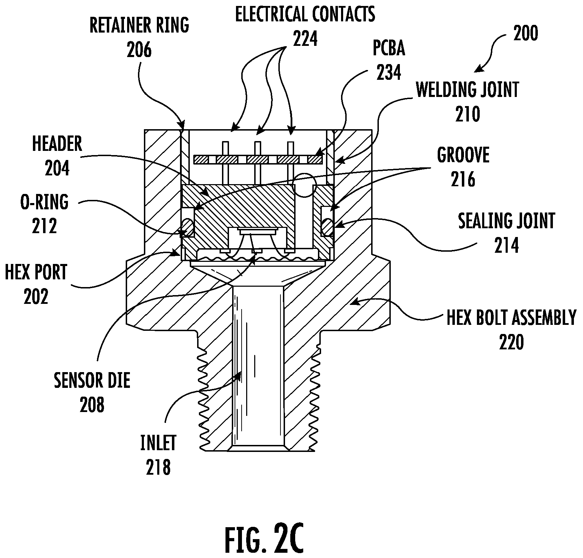

FIG. 2C is a cross-sectional view of an example pressure sensor 200 in accordance with some embodiments of the present disclosure. The hex port 202 comprises a circumference that is appropriately sized for receiving the header 204 and a retainer ring 206. As depicted in FIG. 2C, the header 204 is seated at the base of the hex port 202. The header 204 is configured within the hex port 202 wherein the sensor die 208 is (i) seated along with the header 204 at a base of the hex port 202 and (ii) interfaced with the inlet 218 of the hex bolt assembly. As such, media received at the inlet 218 may be measured by the sensor die 208.

The retainer ring 206 may be configured to retain the header 204 in the hex port 202 by positioning the retainer ring 206 in the hex port 202 over the header 204 and capping the hex port 202 by welding the retainer ring 206 in the hex port 202 at the welding joint 210. In some example embodiments, as depicted in FIG. 2C, the retainer ring 206 is configured at an electrical contacts (e.g., electrical contacts 224) end of hex port 202 that is opposite of the inlet 218 such that the header 204 is retained between the retainer ring 206 and the inlet 218. The retainer ring 206 comprises a tubular shape with a uniform or tapered circumference that is approximately equal to and/or less than a circumference of the hex port 202. Compared to retainer ring 106, the retainer ring 206 excludes a flange edge that the retainer ring 106 comprises for joining with a collar edge of the hex bolt assembly 120.

The header 204 may be the same or substantially similar to the header 104 of FIG. 1A through FIG. 1D. However, as disclosed above, the header 104 comprises a groove 122 that is unutilized in pressure sensor 100. According to various embodiments of the present disclosure, the header 204 comprises a groove 216 within a midsection of the circumference of the header 204. An O-ring 212 is provided in the groove 216 to create a sealing joint 214 that is between the groove 216 and a sidewall of the hex port 202. In some embodiments, the retainer ring 206 may be welded in the hex port 202 at welding joint 210 to provide an additional seal with the hex port 202 that prevents leaks from the header 204 through the sealing joint 214.

Accordingly, the pressure sensor 200 provides a plurality of advantages including (i) an unnecessarily complex design of the hex port 202 and retainer ring 206 which may reduce machining cost and/or complexity, (ii) a reduction and/or elimination of welding joints which may reduce weld leak paths or failure caused by welding defects.

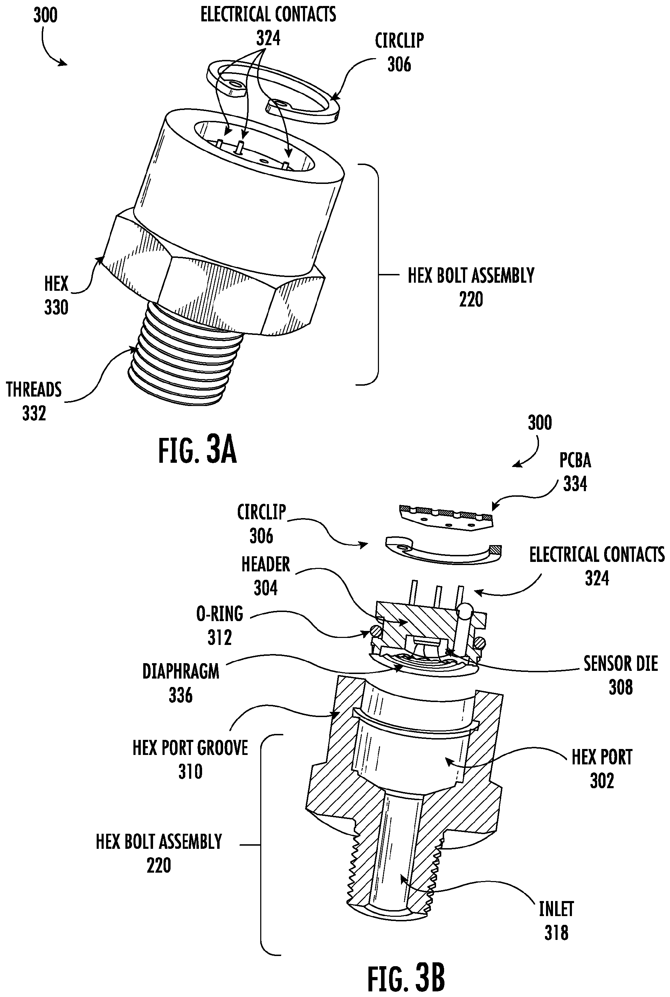

FIG. 3A is a perspective view of an example pressure sensor 300 in accordance with some embodiments of the present disclosure. The pressure sensor 300 comprises a hex bolt assembly 320, a plurality of electrical contacts 324, and a circlip 306. The plurality of electrical contacts 324 may be coupled to sensor electronics that are housed within the hex bolt assembly 320. The circlip 306 may be configured to retain the sensor electronics and other sensor components within the hex bolt assembly 320. The hex bolt assembly 320 comprises a hex 330 and threads 332. The hex 330 allows for a tool to apply torque on the hex bolt assembly 320 such that the threads 332 may be fastened or unfastened to a system measured.

FIG. 3B is an exploded cross-sectional view of an example pressure sensor 300 in accordance with some embodiments of the present disclosure. The hex bolt assembly 320 further comprises a hex port 302 and an inlet 318. The hex port 302 may comprise a cylindrically-shaped inner cavity that is defined by an inner cavity sidewall within the hex bolt assembly 320. The inlet 318 is coupled to a base of the hex port 302. The inlet 318 may be configured to receive and guide media (e.g., fluids) from a pressure line (e.g., that may be coupled to the inlet 318) to the hex port 302. The pressure sensor 300 further comprises a header 304. The header 304 comprises (i) a sensor die 308 that is integrated within a chamber of the header 304, (ii) a fill fluid (e.g., silicon or transformer oil) within the chamber, and (iii) a diaphragm 336 that provides an interface between the sensor die 308, the fill fluid, and the inlet 318. A PCBA 334 may comprise circuity that is coupled to the electrical contacts 324 and the sensor die 308. In some embodiments, the electrical contacts 324 are soldered to the PCBA 334 and configured to conduct electrical output generated by the sensor die 308 that is representative of a sensed pressure by the sensor die 308.

The sensor die 308 may comprise one or more elements that are configured to convert mechanical movement, stress and/or deflection of sensor die 308 into an electrical signal. In some embodiments, the sensor die 308 comprises piezoresistive materials that include any material that exhibits a change in electrical resistance in response to mechanical force or pressure applied to the material. For example, when force or pressure is applied to the sensor die 308, resistance between wire bonds that are connected by the piezoresistive materials may change in a time-varying manner that is based on an applied force. A signal representative of a magnitude of an applied force on the sensor die 308 may be generated by the sensor die 308 and transferred by electrical contacts 324 based on the change in the resistance.

The hex port 302 also excludes a notch that the hex port 102 (of the pressure sensor 100 of FIG. 1A through FIG. 1D) comprises for joining with a collar of the retainer ring 106 or for welding at the second joint 112. The hex port 302 further comprises a hex port groove 310. The hex port groove 310 is provided in the hex port 302 a specific distance from an end of the hex port 302 opposite of the inlet 318 that, when the header 304 is seated at the base of the hex port 302, allows for clearance above the header 304. The circlip 306 may comprise a retaining ring that is inserted from an opening at an electrical contact (e.g., electrical contacts 324) end of the hex bolt assembly 320 into the hex port 302 and configured (e.g., snapped) into the hex port groove 310. The circlip 306 may be configured to retain the header 304 in the hex port 302 by pinning the header 304 below the circlip 306 while positioned in the hex port groove 310. In some example embodiments, the circlip 306 is configured in the hex port groove 310 such that the header 304 is retained between the circlip 306 and the inlet 318. Accordingly, the circlip 306 replaces a need for welding a retainer ring and/or welding joints.

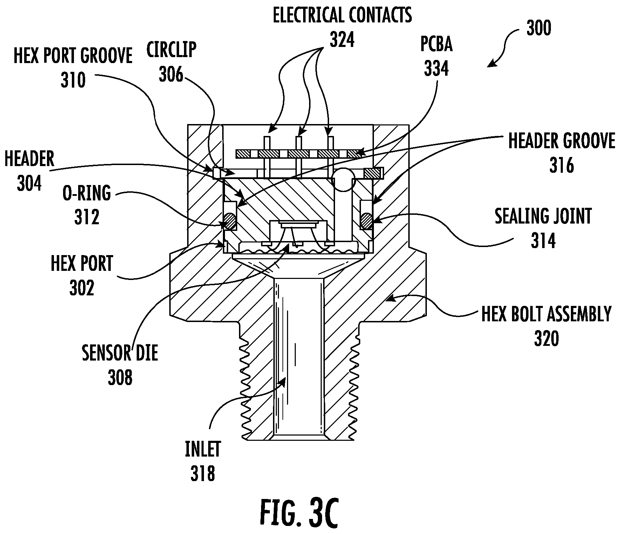

FIG. 3C is a cross-sectional view of an example pressure sensor 300 in accordance with some embodiments of the present disclosure. The hex port 302 may comprise a circumference that is appropriately sized for receiving the header 304. As depicted in FIG. 3C, the header 304 is seated at the base of the hex port 302. A sensor die 308 is integrated within a cavity of the header 304 that may be filled with a fill fluid (e.g., silicon or transformer oil). The header 304 is configured within the hex port 302 wherein the sensor die 308 is (i) seated along with the header 304 at a base of the hex port 302 and (ii) interfaced with the inlet 318. As such, media received at the inlet 318 may be measured by the sensor die 308.

The header 304 comprises a header groove 316 within a midsection of the circumference of the header 304. An O-ring 312 is provided in the header groove 316 to create a sealing joint 314 that is between the header groove 316 and a sidewall of the hex port 302.

The pressure sensor 300 provides a plurality of advantages including (i) an unnecessarily complex design of the hex port 302 and replacement of retainer ring with a circlip 306 which may reduce machining cost and/or complexity, (ii) an elimination of welding joints which eliminates weld leak paths or failure caused by welding defects.

It is to be understood that the disclosure is not to be limited to the specific embodiments disclosed, and that modifications and other embodiments are intended to be included within the scope of the appended claims. Although specific terms are employed herein, they are used in a generic and descriptive sense only and not for purposes of limitation, unless described otherwise.

## Claims

1. A pressure sensor comprising:
a hex bolt assembly comprising a hex port and an inlet that is coupled to a base of the hex port;
a header that is configured at the base of the hex port, wherein the header comprises (i) a groove within a circumference of the header and (ii) an O-ring in the groove that forms a sealing joint between the groove and a sidewall of the hex port; and
a retainer ring that is configured in the hex port to retain the header between the retainer ring and the inlet.

2. The pressure sensor of claim 1, wherein the header further comprises a sensor die that is (i) integrated within a cavity of the header and (ii) interfaced with the inlet.

3. The pressure sensor of claim 2 further comprising:
one or more electrical contacts; and
a printed circuit board assembly that is coupled to the one or more electrical contacts and the sensor die.

4. The pressure sensor of claim 3, wherein the one or more electrical contacts are (i) soldered to the printed circuit board assembly, and (ii) configured to conduct electrical output generated by the sensor die.

5. The pressure sensor of claim 1, wherein the hex port comprises a cylindrically-shaped inner cavity that is defined by an inner cavity sidewall within the hex bolt assembly.

6. The pressure sensor of claim 1, wherein the retainer ring comprises a tubular shape with a uniform or tapered circumference that is approximately equal to or less than a circumference of the hex port.

7. A pressure sensor comprising:
a hex bolt assembly comprising a hex port and an inlet that is coupled to a base of the hex port, wherein the hex port comprises a hex port groove;
a header that is configured at the base of the hex port, wherein the header comprises (i) a groove within a circumference of the header and (ii) an O-ring in the groove that forms a sealing joint between the groove and a sidewall of the hex port; and
a circlip that is configured in the hex port to retain the header between the circlip and the inlet.

8. The pressure sensor of claim 7, wherein the hex port groove is provided a distance from an end of the hex port opposite of the inlet that, when the header is seated at the base of the hex port, allows for clearance above the header.

9. The pressure sensor of claim 7, wherein the circlip is configured in the hex port groove.

10. The pressure sensor of claim 9, wherein the circlip is configured to retain the header in the hex port by pinning the header below the circlip when the circlip is configured in the hex port groove.

11. The pressure sensor of claim 7, wherein the header further comprises a sensor die that is (i) integrated within a cavity of the header and (ii) interfaced with the inlet.

12. The pressure sensor of claim 7, wherein the hex port comprises a cylindrically-shaped inner cavity that is defined by an inner cavity sidewall within the hex bolt assembly.

13. The pressure sensor of claim 7, wherein the header further comprises a sensor die that is (i) integrated within a cavity of the header and (ii) interfaced with the inlet.

14. The pressure sensor of claim 13 further comprising:
one or more electrical contacts; and
a printed circuit board assembly that is coupled to the one or more electrical contacts and the sensor die.

15. The pressure sensor of claim 14, wherein the one or more electrical contacts are (i) soldered to the printed circuit board assembly, and (ii) configured to conduct electrical output generated by the sensor die.
